# DEMANDE DE BREVET EUROPEEN

(11) **EP 4 737 957 A1**
(43) Date de publication de la demande: **06.05.2026**
(21) Numéro de dépôt: 25211462.4
(22) Date de dépôt: 27.10.2025
(51) Int. Cl.: G02B 5/28, G02B 5/30, G02B 27/28

(54) **FILTRE OPTIQUE**

(30) Priorité: 04.11.2024 FR 2412061
(71) Demandeur: Commissariat à l'Energie Atomique et aux Energies Alternatives, 75015 Paris (FR)
(72) Inventeur: PELLE, Catherine, 38054 Grenoble Cedex 09 (FR)
(74) Mandataire: Cabinet Beaumont

(57) **Abrégé**

La présente description concerne un filtre optique (100) comprenant une superposition de :
- au moins des première (111a) et deuxième (111b) cavités résonnantes ; et
- au moins un premier filtre polariseur (113a).

## Description

### Domaine technique

La présente description concerne de façon générale les filtres optiques, et en particulier les filtres spectraux polariseurs. Un filtre spectral polariseur est un filtre optique adapté à transmettre majoritairement un rayonnement compris dans au moins une certaine plage de longueurs d'onde et présentant au moins une certaine polarisation.

### Technique antérieure

De nombreux filtres optiques, notamment des filtres spectraux polariseurs, ont été proposés. Toutefois, les filtres optiques existants présentent divers inconvénients.

La demande internationale WO2018/070269 décrit un dispositif optique permettant de supprimer une diminution du rapport d'extinction de la lumière transmise. Toutefois, ce dispositif optique ne permet d'obtenir qu'un faible contraste d'intensité entre la lumière polarisée « s », présentant une polarisation linéaire orthogonale au plan d'incidence, et la lumière polarisée « p », présentant une polarisation linéaire parallèle au plan d'incidence. En outre, la réalisation du dispositif nécessite une profondeur de gravure importante et requiert de graver des matériaux différents.

Le brevet américain US9601532 décrit un filtre optique comprenant un résonateur de type Fabry-Perot comportant un polariseur à grille métallique en forme de plaque. Toutefois, ce filtre présente une faible résilience à l'angle d'incidence de la lumière : l'intensité lumineuse transmise par le filtre diminue fortement lorsque l'angle d'incidence augmente.

Le brevet européen EP3839454 décrit un filtre spectral polariseur comprenant un réseau constitué de barres en des matériaux d'indices optiques différents interposé entre des réflecteurs comprenant chacun une alternance de couches en ces matériaux. Toutefois, ce filtre présente une bande de transmission étroite et une forte sensibilité aux variations de longueur d'onde, d'épaisseur et d'angle d'incidence.

### Résumé de l'invention

Il existe un besoin de pallier tout ou partie des inconvénients des filtres optiques existants, notamment des filtres spectraux polariseurs existants. En particulier, il serait souhaitable d'améliorer la résilience à l'angle d'incidence des filtres existants.

Pour cela, un mode de réalisation prévoit un filtre optique comprenant une superposition de :
- au moins des première et deuxième cavités résonnantes ; et
- au moins un premier filtre polariseur.

Selon un mode de réalisation, le filtre optique comprend en outre un deuxième filtre polariseur, les premier et deuxième filtres polariseurs étant respectivement situés dans les première et deuxième cavités résonnantes.

Selon un mode de réalisation, le filtre optique comprend en outre une troisième cavité résonnante interposée entre les première et deuxième cavités résonnantes, chaque premier filtre polariseur étant situé dans l'une des première, deuxième et troisième cavités résonnantes.

Selon un mode de réalisation, le filtre optique comprend un seul premier filtre polariseur situé de préférence dans la troisième cavité résonnante.

Selon un mode de réalisation, chaque cavité résonnante est interposée entre des empilements comprenant chacun une alternance :
- d'au moins deux premières couches en un premier matériau isolant présentant un premier indice optique ; et
- d'au moins une deuxième couche en un deuxième matériau isolant présentant un deuxième indice optique strictement supérieur au premier indice optique.

Selon un mode de réalisation, les premier et deuxième matériaux isolants sont choisis parmi :
- des oxydes, par exemple l'oxyde de silicium, l'oxyde de titane, l'oxyde de niobium, l'oxyde de tantale, etc. ;
- des nitrures, par exemple le nitrure de silicium ; et
- le silicium amorphe.

Selon un mode de réalisation, chaque première couche et chaque deuxième couche présente une épaisseur quart d'onde.

Selon un mode de réalisation, chaque cavité résonnante présente une épaisseur demi-onde.

Selon un mode de réalisation, chaque filtre polariseur comprend un réseau de barres parallèles alternées comportant :
- des premières barres en un troisième matériau présentant un troisième indice optique ; et
- des deuxièmes barres en un quatrième matériau isolant présentant un quatrième indice optique strictement supérieur au troisième indice optique.

Selon un mode de réalisation, les troisième et quatrième matériaux sont respectivement identiques aux premier et deuxième matériaux.

Selon un mode de réalisation, le troisième matériau est un matériau métallique, par exemple l'argent ou l'aluminium.

Selon un mode de réalisation, les réseaux de barres des premier et deuxième filtres polariseurs présentent un pas identique.

Selon un mode de réalisation, les réseaux de barres des premier et deuxième filtres polariseurs présentent des pas différents.

Un mode de réalisation prévoit un filtre optique tel que décrit, destiné à être placé en vis-à-vis d'une matrice de pixels d'un capteur d'images, le filtre optique étant adapté à transmettre un rayonnement incident majoritairement dans une première plage de longueurs d'onde et selon une première polarisation à certains pixels du capteur, et majoritairement dans au moins une deuxième plage de longueurs d'onde, différente de la première plage de longueurs d'onde, et/ou selon au moins une deuxième polarisation, différente de la première polarisation, à d'autres pixels du capteur.

Un mode de réalisation prévoit un capteur multispectral ou hyperspectral comprenant un capteur d'images comportant une matrice de pixels en vis-à-vis desquels est situé un filtre optique tel que décrit.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :

la figure 1 est une vue en perspective, schématique et partielle, d'un filtre optique selon un mode de réalisation ;

la figure 2 est un logigramme illustrant des étapes d'un procédé de conception et d'optimisation du filtre optique de la figure 1 selon un mode de réalisation ;

la figure 3 est un graphique comparatif illustrant la résilience à l'angle d'incidence de différents filtres optiques ; et

la figure 4 est une vue en perspective, schématique et partielle, d'un filtre optique selon un mode de réalisation.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, les différentes applications des filtres optiques de la présente description, notamment les divers dispositifs optiques susceptibles d'intégrer ces filtres, n'ont pas été détaillées, les modes de réalisation décrits étant compatibles avec tous ou la plupart des applications et dispositifs optiques usuels mettant en œuvre au moins un filtre optique, moyennant éventuellement des adaptations à la portée de la personne du métier à la lecture de la présente description.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais « coupled ») entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes « avant », « arrière », « haut », « bas », « gauche », « droite », etc., ou relative, tels que les termes « dessus », « dessous », « supérieur », « inférieur », etc., ou à des qualificatifs d'orientation, tels que les termes « horizontal », « vertical », etc., il est fait référence, sauf précision contraire, à l'orientation des figures.

Sauf précision contraire, les expressions « environ », « approximativement », « sensiblement », et « de l'ordre de » signifient à 10 % ou à 10° près, de préférence à 5 % ou à 5° près.

Dans la description qui suit, les qualificatifs « isolant » et « conducteur » signifient respectivement, sauf précision contraire, électriquement isolant et électriquement conducteur.

Sauf précision contraire, l'expression « en contact avec » signifie « en contact mécanique avec ».

Dans la description qui suit, l'expression « transmission d'un filtre » désigne un rapport entre l'intensité d'un rayonnement sortant du filtre et l'intensité du rayonnement entrant dans le filtre.

Dans la description qui suit, l'expression « longueur d'onde centrale d'un filtre » désigne la longueur d'onde qui se situe au centre de la plage de longueurs d'onde de transmission du filtre considéré.

Dans la description qui suit, l'expression « résilience à l'angle d'incidence d'un filtre » désigne la capacité du filtre à transmettre un rayonnement incliné par rapport à l'axe optique, c'est-à-dire incliné par rapport à une direction orthogonale à une face du filtre destinée à être illuminée par le rayonnement.

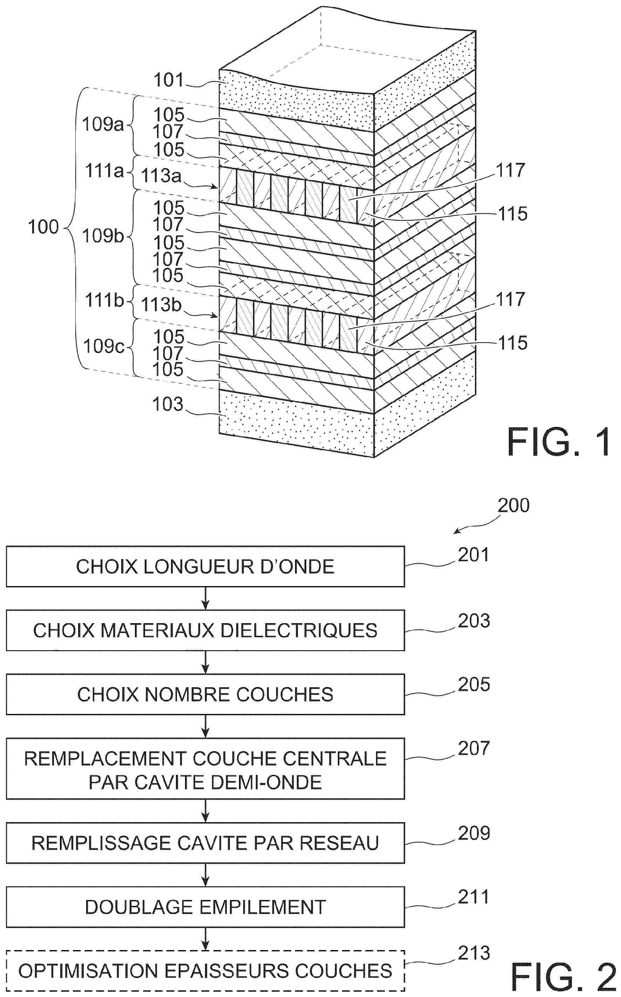

La figure 1 est une vue en perspective, schématique et partielle, d'un filtre optique 100 selon un mode de réalisation.

Le filtre 100 est par exemple destiné à être placé en vis-à-vis d'une matrice de pixels d'un capteur d'images, par exemple pour former un capteur multispectral ou hyperspectral. Le filtre 100 est alors par exemple adapté à transmettre un rayonnement incident majoritairement dans une première plage de longueurs d'onde et selon une première polarisation à certains pixels du capteur, et majoritairement dans au moins une deuxième plage de longueurs d'onde, différente de la première plage de longueurs d'onde, et/ou selon au moins une deuxième polarisation, différente de la première polarisation, à d'autres pixels du capteur.

À titre de variante, le filtre optique 100 est adapté à transmettre un rayonnement incident majoritairement dans une seule plage de longueurs d'onde et selon une seule polarisation. Par ailleurs, le filtre 100 peut être destiné à être associé à des dispositifs autres qu'un capteur d'images.

Dans l'exemple représenté, le filtre 100 est interposé entre un milieu d'entrée 101, duquel provient un rayonnement illuminant le filtre 100, et un milieu de sortie 103, vers lequel est transmis le rayonnement filtré. Dans le cas où le filtre 100 est destiné à être disposé au-dessus d'un capteur d'images, le milieu d'entrée 101 est par exemple opposé à la matrice de pixels du capteur d'images et le milieu de sortie 103 est tourné vers la matrice de pixels du capteur d'images. Le milieu d'entrée 101 est par exemple constitué d'air.

Dans l'exemple illustré en figure 1, le filtre optique 100 comprend des couches diélectriques 105 et 107 alternées. Les couches 105 sont en au moins un matériau isolant, ou diélectrique, présentant un indice optique, ou indice de réfraction, n1. En outre, les couches 107 sont en au moins un autre matériau isolant présentant un indice optique n2 strictement supérieur à l'indice optique n1.

À titre d'exemple, les matériaux des couches 105 et 107 sont choisis parmi :
- des oxydes, par exemple l'oxyde de silicium, l'oxyde de titane, l'oxyde de niobium, l'oxyde de tantale, etc. ;
- des nitrures, par exemple le nitrure de silicium ; et
- le silicium amorphe.

De préférence, les couches 105 sont toutes en le matériau isolant d'indice optique n1 et les couches 107 sont toutes en le matériau isolant d'indice optique n2. Cela facilite la conception et la fabrication du filtre 100. À titre d'exemple, les couches diélectriques 105 et 107 sont respectivement en oxyde de silicium et en silicium amorphe. Dans cet exemple, les indices optiques n1 et n2 sont respectivement égaux à environ 1,5 et 3,8 pour un rayonnement présentant une longueur d'onde égale à environ 940 nm.

Dans l'exemple représenté, le filtre 100 comprend plus précisément, entre les milieux d'entrée 101 et de sortie 103, trois empilements 109a, 109b et 109c de couches diélectriques 105 et 107 alternées. Dans cet exemple, l'empilement 109b est situé entre les empilements 109a et 109c. Les empilements 109a, 109b et 109c forment par exemple chacun un réflecteur. Les empilements 109a, 109b et 109c présentent par exemple une structure de type « miroir de Bragg ».

La figure 1 illustre un exemple dans lequel chaque empilement 109a, 109c comprend deux couches 105 et une couche 107 alternées, c'est-à-dire une couche 107 interposée entre deux couches 105. Par ailleurs, dans cet exemple, l'empilement 109b comprend trois couches 105 et deux couches 107 alternées, c'est-à-dire que chaque couche 107 de l'empilement 109b est interposée entre deux couches 105 voisines. Cet exemple n'est toutefois pas limitatif et chaque empilement 109a, 109b, 109c peut, à titre de variante, comprendre des nombres de couches 105 et 107 différents de ceux représentés.

Chaque couche diélectrique 105, 107 présente par exemple une épaisseur E1 dite « quart d'onde », ou « λ/4n », c'est-à-dire une épaisseur sensiblement égale à la longueur d'onde λ centrale du filtre optique 100 divisée par quatre fois l'indice optique n1, n2 de la couche.

Selon un mode de réalisation, le filtre optique 100 comprend en outre des cavités résonnantes 111a et 111b. Dans l'exemple illustré en figure 1, la cavité résonnante 111a est interposée entre les empilements 109a et 109b, et la cavité résonnante 111b est interposée entre les empilements 109b et 109c.

Chaque cavité résonnante 111a, 111b comprend par exemple un filtre polariseur 113a, 113b. Dans l'exemple représenté, les cavités résonnantes 111a et 111b présentent une épaisseur supérieure ou égale à « 2*λ/4n », c'est-à-dire une épaisseur supérieure ou égale à deux fois la longueur d'onde λ centrale du filtre optique 100 divisée par quatre fois l'indice optique n1, n2 de la cavité 111a, 111b. À titre de variante, chaque cavité résonnante 111a, 111b présente une épaisseur égale à au moins k fois l'épaisseur E1 du matériau constitutif de la couche diélectrique 107, avec k un entier supérieur ou égal à deux. Dans l'exemple illustré, chaque filtre polariseur 113a, 113b s'étend verticalement sur toute l'épaisseur de la cavité résonnante 111a, 111b et s'étend latéralement sur toute la surface de la cavité résonnante 111a, 111b. Dans cet exemple, chaque filtre polariseur 113a, 113b occupe l'intégralité du volume interne de la cavité résonnante 111a, 111b.

Dans l'exemple illustré, chaque filtre polariseur 113a, 113b comprend une structure périodique comportant des barres 115 et 117 alternées et parallèles entre elles, les barres 115 et 117 s'étendant latéralement le long d'une direction sensiblement horizontale. Les barres 115 sont par exemple en un matériau isolant présentant un indice optique n3 et les barres 117 sont par exemple en un autre matériau isolant présentant un indice optique n4 strictement supérieur à l'indice optique n3.

De préférence, les barres 115 sont en le même matériau que les couches diélectriques 105, c'est-à-dire le matériau isolant d'indice optique n1, et les barres 117 sont en le même matériau que les couches diélectriques 107, c'est-à-dire le matériau isolant d'indice optique n2. Cela permet de simplifier la conception et la réalisation du filtre optique 100.

Bien que la figure 1 illustre un exemple dans lequel le filtre optique 100 comprend deux cavités résonnantes 111a et 111b, cet exemple n'est pas limitatif et le filtre optique 100 peut, à titre de variante, comprendre un nombre de cavités résonnantes strictement supérieur à deux, chaque cavité résonnante étant alors par exemple interposée entre des empilements de couches 105 et 107 alternées analogues aux empilements 109a, 109b et 109c. L'augmentation du nombre de cavités résonnantes dans la structure entraîne un élargissement de la plage de longueurs d'onde transmises par le filtre optique 100.

Chaque cavité résonnante 111a, 111b présente par exemple une épaisseur E2 dite « demi-onde », ou « λ/2n », c'est-à-dire une épaisseur sensiblement égale à environ la longueur d'onde λ centrale du filtre optique 100 divisée par deux fois un indice optique effectif neff de la cavité résonnante. À titre de variante, chaque cavité résonnante 111a, 111b présente une épaisseur égale à k fois l'épaisseur E2.

Un avantage du filtre optique 100 est qu'il combine une fonction de filtrage interférentiel en longueurs d'onde avec une fonction de filtrage de la polarisation (polariseur) sans perte d'intensité lumineuse et tout en présentant une résilience à l'angle d'incidence bien supérieure à celle des filtres polariseurs existants. En outre, un avantage du filtre optique 100 est que, dans le cas où seuls deux matériaux d'indices optiques n1 et n2 différents sont utilisés pour réaliser les couches diélectriques et les cavités résonnantes de la structure du filtre, la fabrication du filtre optique 100 ne requiert la gravure que d'un seul de ces deux matériaux. Cela facilite la fabrication du filtre optique 100.

La figure 2 est un logigramme illustrant des étapes d'un procédé 200 de conception et d'optimisation du filtre optique 100 de la figure 1 selon un mode de réalisation.

Dans le cas où le filtre optique 100 est destiné à être intégré dans un capteur multispectral ou hyperspectral, les étapes ci-dessous sont par exemple mises en œuvre pour chaque partie du filtre destinée à être placée en vis-à-vis d'au moins un pixel d'un capteur d'images et étant adaptée à transmettre, vers ce ou ces pixels, un rayonnement incident majoritairement dans une certaine plage de longueurs d'onde et selon une certaine polarisation. À titre de variante, par exemple dans le cas où le filtre 100 est destiné à réaliser une fonction de filtrage global, les étapes ci-dessous peuvent être mises en œuvre une seule fois pour la totalité du filtre.

Au cours d'une étape 201, un choix de longueur d'onde λ centrale est effectué. À titre d'exemple, la longueur d'onde λ est choisie égale à environ 940 nm.

Au cours d'une autre étape 203, postérieure à l'étape 201, un choix de matériaux diélectriques est effectué. Des matériaux diélectriques transparents à la longueur d'onde λ centrale et présentant un contraste d'indices optiques le plus important possible sont par exemple choisis lors de l'étape 203. Pour simplifier, il est ci-dessous pris pour exemple le cas où seuls deux matériaux isolants d'indices optiques différents - en l'espèce l'oxyde de silicium (SiO₂, d'indice optique n1) et le silicium amorphe (aSi, d'indice optique n2 > n1) - sont utilisés pour réaliser les couches diélectriques 105 et 107 et les barres 115 et 117 des filtres polariseurs 113a et 113b. Toutefois, la personne du métier est bien entendu capable, à partir des indications de la présente description, de transposer cet exemple à des cas dans lesquels plus de deux matériaux isolants différents sont utilisés pour fabriquer le filtre optique 100.

Au cours d'une autre étape 205, postérieure à l'étape 203, un choix de nombre de couches diélectriques est effectué. À partir de la longueur d'onde λ et du choix des matériaux diélectriques est conçu un empilement de type miroir de Bragg, comprenant, entre les milieux d'entrée 101 et de sortie 103, un multiple N de bicouches (avec N un entier non nul, par exemple égal à 4) d'oxyde de silicium et de silicium amorphe, plus une couche d'oxyde de silicium. Dit autrement, cela revient à former un empilement constitué d'une alternance de 2*N couches en matériau d'indice n2 et de 2*N + 1 couches en matériau d'indice n1, les couches inférieure et supérieure de l'empilement étant en le matériau d'indice n1 (c'est-à-dire l'oxyde de silicium, dans cet exemple). Le choix du nombre N est par exemple fonction du contraste d'indices optiques (de la différence entre n1 et n2, dans cet exemple) : plus le contraste d'indices optiques est faible, plus le nombre N est grand afin d'optimiser les réjections du filtre.

Le tableau ci-dessous détaille un exemple d'un tel empilement, les couches diélectriques étant numérotées par ordre croissant depuis le milieu d'entrée 101 vers le milieu de sortie 103. Dans ce tableau, l'épaisseur de chaque couche est exprimée en multiples de λ/4n et en nanomètres (nm), et la lettre « n » représente l'indice optique à la longueur d'onde λ considérée.

**[Table 1]**

| N° couche | Matériau | n | Épaisseur (λ/4n) | Épaisseur (nm) |
|---|---|---|---|---|
| 1 | SiO₂ | 1,46 | 1 | 162 |
| 2 | aSi | 3,78 | 1 | 62 |
| 3 | SiO₂ | 1,46 | 1 | 162 |
| 4 | aSi | 3,78 | 1 | 62 |
| 5 | SiO₂ | 1,46 | 1 | 162 |
| 6 | aSi | 3,78 | 1 | 62 |
| 7 | SiO₂ | 1,46 | 1 | 162 |

Dans l'exemple ci-dessus, l'empilement comprend deux alternances aSi/SiO₂ situées de part et d'autre d'une couche aSi (couche n° 4) d'épaisseur λ/4n.

Au cours d'une autre étape 207, postérieure à l'étape 205, la couche diélectrique centrale de l'empilement (c'est-à-dire la couche n° 5, dans l'exemple ci-dessus) est remplacée par une cavité résonnante demi-onde. Cela permet de réaliser un filtre transmettant une plage de longueurs d'onde centrée sur la longueur d'onde λ.

Le tableau ci-dessous détaille la structure obtenue à l'issue de l'étape 207 dans le cas de l'exemple précédent :

**[Table 2]**

| N° couche | Matériau | n | Épaisseur (λ/4n) | Épaisseur (nm) |
|---|---|---|---|---|
| 1 | SiO₂ | 1,46 | 1 | 162 |
| 2 | aSi | 3,78 | 1 | 62 |
| 3 | SiO₂ | 1,46 | 1 | 162 |
| 4 | aSi | 3,78 | 2 | 124 |
| 5 | SiO₂ | 1,46 | 1 | 162 |
| 6 | aSi | 3,78 | 1 | 62 |
| 7 | SiO₂ | 1,46 | 1 | 162 |

Dans l'exemple ci-dessus, l'empilement comprend deux alternances aSi/SiO₂ situées de part et d'autre d'une couche aSi (couche n° 4) d'épaisseur 2*λ/4n (= λ/2n). Bien que l'exemple ci-dessus détaille un cas dans lequel la cavité résonnante présente une épaisseur demi-onde, cet exemple n'est pas limitatif et la cavité peut, à titre de variante, présenter une épaisseur égale à un multiple entier supérieur à deux de la demi-onde. Le choix de l'épaisseur de la cavité résonnante est par exemple fonction du contraste d'indices optiques (de la différence entre n1 et n2, dans cet exemple) : plus le contraste est faible, plus l'épaisseur de la cavité résonnante est importante afin d'obtenir un contraste de transmission élevé entre une polarisation s, c'est-à-dire une polarisation linéaire sensiblement orthogonale au plan d'incidence, et une polarisation p, c'est-à-dire une polarisation linéaire sensiblement parallèle au plan d'incidence et sensiblement orthogonale à la polarisation s.

Au cours d'une autre étape 209, postérieure à l'étape 207, la cavité résonnante, constituée par la couche centrale de l'empilement, est remplie par un réseau formant un filtre polariseur. Cela permet de séparer les polarisations s et p. À titre d'exemple, le réseau comprend une alternance de barres parallèles en le matériau de bas indice n1 et de barres parallèles en le matériau de haut indice n2 s'étendant dans le plan de la cavité résonnante orthogonalement à l'empilement.

L'épaisseur de la couche centrale, donc de la cavité résonnante, peut être ajustée lors de l'étape 209 afin que, pour la polarisation s ou p désirée, la structure présente un pic de transmission à la longueur d'onde λ centrale choisie à l'étape 201.

Le tableau ci-dessous détaille la structure obtenue à l'issue de l'étape 209 dans le cas de l'exemple précédent, en choisissant de transmettre la polarisation s à la longueur d'onde λ :

**[Table 3]**

| N° couche | Matériau | n | Épaisseur (λ/4n) | Épaisseur (nm) |
|---|---|---|---|---|
| 1 | SiO₂ | 1,46 | 1 | 162 |
| 2 | aSi | 3,78 | 1 | 62 |
| 3 | SiO₂ | 1,46 | 1 | 162 |
| 4 | aSi | 3,78 | - | 156 |
| 5 | SiO₂ | 1,46 | 1 | 162 |
| 6 | aSi | 3,78 | 1 | 62 |
| 7 | SiO₂ | 1,46 | 1 | 162 |

Dans l'exemple ci-dessus, le pic de transmission de la polarisation p est obtenu à une longueur d'onde égale à environ 850 nm.

La structure obtenue à l'issue des étapes 201 à 209 constitue un filtre optique dit « piqué », c'est-à-dire dont la transmission diminue fortement lorsque l'angle d'incidence augmente. À titre d'exemple, lorsque le filtre est illuminé par un rayonnement de longueur d'onde λ égale à 940 nm, la transmission est, pour des angles d'incidence supérieurs à 10°, inférieure à 20 % de la transmission maximale, obtenue pour un angle d'incidence nul (rayonnement orienté le long de l'axe optique).

Au cours d'une autre étape 211, postérieure à l'étape 209, l'empilement précédemment décrit est doublé, ou dupliqué. L'étape 211 a pour conséquence d'augmenter le nombre de cavités résonnantes 111a, 111b, ce qui permet d'élargir la fenêtre de transmission maximale du filtre 100.

Les deux empilements sont superposés de sorte que la couche inférieure de l'empilement supérieur (couche 7, dans l'exemple ci-dessus) coïncide avec la couche supérieure de l'empilement inférieur (couche 1, dans cet exemple). En outre, la couche supérieure de l'empilement supérieur (couche 1, dans l'exemple ci-dessus) et la couche inférieure de l'empilement inférieur (couche 7, dans cet exemple) sont par exemple retirées. Le filtre optique 100 précédemment décrit en relation avec la figure 1 est ainsi obtenu.

Le tableau ci-dessous détaille la structure obtenue à l'issue de l'étape 211 dans le cas de l'exemple précédent, en choisissant de transmettre la polarisation s à la longueur d'onde λ :

**[Table 4]**

| N° couche | Référence | Matériau | Épaisseur (λ/4n) |
|---|---|---|---|
| 1 | 105 | SiO₂ | 1 |
| 2 | 107 | aSi | 1 |
| 3 | 105 | SiO₂ | 1 |
| 4 | 111a | aSi/SiO₂ | 2 |
| 5 | 105 | SiO₂ | 1 |
| 6 | 107 | aSi | 1 |
| 7 | 105 | SiO₂ | 1 |
| 8 | 107 | aSi | 1 |
| 9 | 105 | SiO₂ | 1 |
| 10 | 111b | aSi/SiO₂ | 2 |
| 11 | 105 | SiO₂ | 1 |
| 12 | 107 | aSi | 1 |
| 13 | 105 | SiO₂ | 1 |

À l'issue des étapes 201 à 211, un empilement quart d'onde comprenant deux cavités résonnantes 111a et 111b est obtenu. Dans cet empilement, plus le nombre de bicouches interposés entre les cavités résonnantes 111a et 111b est important, plus la plage de longueurs d'onde transmises par le filtre optique 100 est étroite.

Les filtres polariseurs 113a et 113b des cavités résonnantes 111a et 111b de la structure sont adaptés à filtrer une même polarisation. Dans le cas où les cavités résonnantes 111a et 111b comprennent chacune un réseau de barres formant un filtre polariseur, les barres des deux réseaux sont par exemple sensiblement parallèles entre elles.

Au cours d'une étape optionnelle 213, postérieure à l'étape 211, les épaisseurs des couches du filtre optique 100 sont optimisées, par exemple à l'aide d'un produit programme d'ordinateur comprenant des instructions de code de programme conduisant à la mise en œuvre d'un procédé d'optimisation du filtre 100 lorsqu'elles sont exécutées par un ordinateur.

À titre d'exemple, l'épaisseur de chaque couche de l'empilement du filtre optique 100 constitue un paramètre d'ajustement. Les épaisseurs initiales prises en compte pour l'optimisation sont par exemple celles du tableau 4 ci-dessus (couches d'épaisseur quart d'onde et cavités résonnantes d'épaisseur demi-onde). Les conditions limites sont fixées par exemple par :
- la longueur d'onde λ centrale du filtre optique 100 ;
- une gamme d'angles d'incidence pour laquelle il est souhaité que le filtre optique 100 soit fonctionnel ; et
- des épaisseurs minimales et maximales.

L'étape 213 d'optimisation permet avantageusement d'améliorer davantage la résilience en angle du filtre optique 100. À titre d'exemple, l'étape 213 est effectuée au moyen d'un logiciel de calcul optique multicouche mis en œuvre par ordinateur.

Le tableau ci-dessous détaille un exemple d'optimisation de la structure obtenue à l'issue de l'étape 213 dans le cas de l'exemple précédent, en choisissant de transmettre la polarisation s à la longueur d'onde λ :

**[Table 5]**

| N° couche | Matériau | Épaisseur (λ/4n) |
|---|---|---|
| 1 | SiO₂ | 2,254 |
| 2 | aSi | 0,884 |
| 3 | SiO₂ | 0,664 |
| 4 | aSi/SiO₂ | 2,407 |
| 5 | SiO₂ | 0,729 |
| 6 | aSi | 0,895 |
| 7 | SiO₂ | 0,804 |
| 8 | aSi | 1,407 |
| 9 | SiO₂ | 0,504 |
| 10 | aSi/SiO₂ | 2,435 |
| 11 | SiO₂ | 0,679 |
| 12 | aSi | 0,926 |
| 13 | SiO₂ | 1,740 |

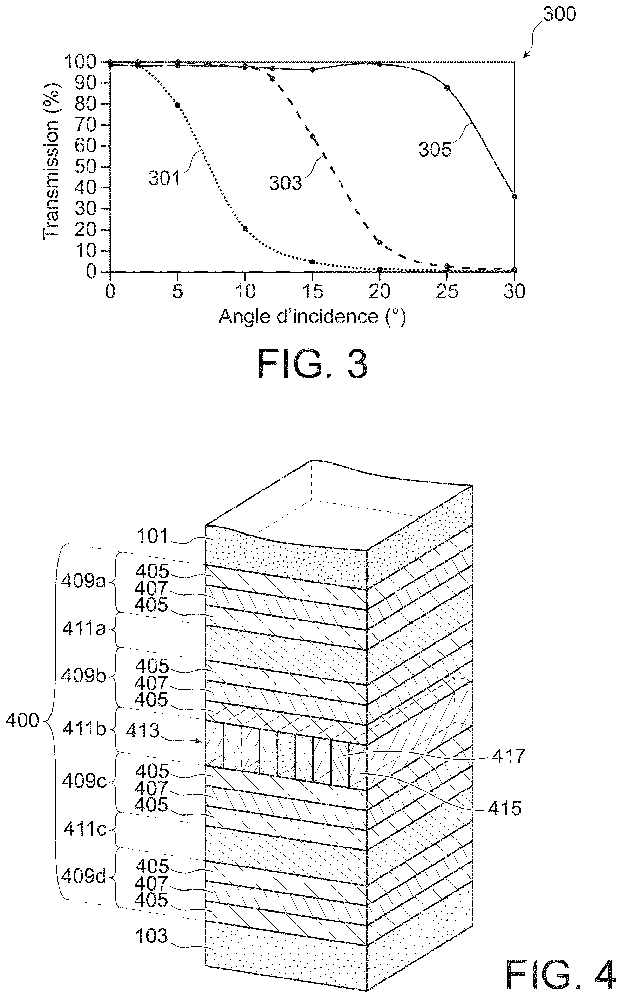

La figure 3 est un graphique 300 comparatif illustrant la résilience à l'angle d'incidence (exprimé en degrés, °) de différents filtres optiques.

Le graphique 300 comprend trois courbes 301, 303 et 305 illustrant des variations de la transmission, exprimée en pourcentage de la transmission maximale obtenue pour un angle d'incidence nul (rayonnement orienté le long de l'axe optique), en fonction de l'angle d'incidence pour, respectivement :
- un filtre optique comprenant une seule cavité résonnante (courbe 301), par exemple le filtre optique du tableau 3 ;
- le filtre optique 100 non optimisé du tableau 4 (courbe 303) ; et
- le filtre optique 100 optimisé du tableau 5 (courbe 305).

Le graphique 300 montre que l'utilisation d'un filtre optique comprenant deux cavités résonnantes, tel que le filtre optique 100, permet d'augmenter la résilience en angle par rapport à un filtre optique ne comprenant qu'une seule cavité résonnante. Par ailleurs, le fait d'optimiser les épaisseurs des couches et des cavités résonnantes du filtre optique 100 permet d'augmenter fortement la résilience en angle par rapport au filtre optique 100 non optimisé.

L'influence de différents paramètres de la structure sur les performances du filtre optique 100 est détaillée ci-dessous.

La description qui suit prend pour exemple le cas où chaque filtre polariseur 113a, 113b du filtre optique 100 comprend les barres parallèles 115 en le matériau de bas indice n1 et les barres parallèles 117 en le matériau de haut indice n2 remplissant totalement tous les espaces libres s'étendant latéralement entre les barres 115. À titre d'exemple, les barres 115 présentent chacune une largeur L1 et les barres 117 présentent chacune une largeur L2.

Dans la description qui suit, l'expression « facteur de forme » désigne un rapport entre la largeur L1 et la somme des largeurs L1 et L2 (F = L1/(L1 + L2), où F désigne le facteur de forme du réseau de barres 115 et 117). En outre, l'expression « période du réseau » désigne la somme des largeurs L1 et L2 (T = L1 + L2, où T désigne la période du réseau).

La résilience à l'angle d'incidence du filtre optique 100 n'est pas modifiée, ou est très faiblement modifiée, en fonction du facteur de forme F pour des valeurs de facteur de forme F allant de 0,1 à 0,9.

En outre, dans un cas où les filtres polariseurs 113a et 113b du filtre optique 100 présentent une structure et des dimensions sensiblement identiques, aux dispersions de fabrication près, la transmission du filtre n'est pas modifiée en cas de décalage latéral d'un filtre polariseur par rapport à l'autre. Dit autrement, le fait que les barres 115 et 117 de l'un des filtres polariseurs 113a, 113b ne soient pas à l'aplomb des barres 115 et 117 de l'autre filtre polariseur 113b, 113a n'impacte pas la transmission du filtre optique 100. Un avantage est que cela facilite la réalisation du filtre optique 100, par exemple du fait du relâchement de contraintes d'alignement de masques de gravure permettant de réaliser les filtres polariseurs 113a et 113b.

À épaisseur physique, ou géométrique, constante du filtre optique 100, le choix du facteur de forme F influe sur la position des plages de longueurs d'onde de transmission respectives des polarisations s et p. En outre, à épaisseur optique constante du filtre optique 100, le choix du facteur de forme F influe sur la position de la plage de longueurs d'onde de transmission de la polarisation p sans modifier, ou en modifiant peu, la position de la plage de longueurs d'onde de transmission de la polarisation s. Dans le cas d'un capteur multispectral ou hyperspectral comprenant le filtre optique 100, le fait de modifier le facteur de forme F en face de différents pixels du capteur d'images permet de transmettre, vers ces pixels, des rayonnements dans différentes plages de longueurs d'onde tout en conservant une épaisseur de filtre constante. Cela facilite la fabrication du filtre optique 100.

Un autre moyen de modifier la plage de longueurs d'onde de transmission du filtre optique 100 consiste à jouer sur l'épaisseur totale de l'empilement de couches et/ou sur l'épaisseur des cavités résonnantes 111a et 111b. Plus les cavités résonnantes 111a et 111b sont épaisses, plus la plage de longueurs d'onde de transmission du filtre optique 100 est décalée vers les longueurs d'onde élevées. Par ailleurs, plus les cavités résonnantes 111a et 111b sont épaisses, plus les plages de longueurs d'onde de transmission des polarisations s et p sont éloignées. Ainsi, le fait d'augmenter l'épaisseur des cavités résonnantes 111a et 111b permet par exemple d'éloigner les plages de longueurs d'onde de transmission des polarisations s et p dans un cas où le contraste d'indices optiques n1 et n2 est faible.

La période T du réseau de barres de chaque filtre polariseur permet un ajustement de la position de la plage de longueurs d'onde de transmission de la polarisation s par rapport à la plage de longueurs d'onde de transmission de la polarisation p. En particulier, le fait d'augmenter la période T tend à rapprocher ces plages l'une de l'autre. Par ailleurs, lorsque la période T du réseau augmente, la largeur de la plage de longueurs d'onde de transmission de la polarisation s demeure sensiblement constante tandis que la largeur de la plage de longueurs d'onde de transmission de la polarisation p diminue. Le facteur de forme F présente, sur les plages de longueurs d'onde de transmission des polarisations s et p, une influence similaire à celle de la période T du réseau.

En outre, il est possible de prévoir que le filtre polariseur 113a présente un facteur de forme F différent de celui du filtre polariseur 113b, par exemple un facteur de forme Fa égal à environ 0,45 pour le filtre polariseur 113a et un facteur de forme Fb égal à environ 0,9 pour le filtre polariseur 113b. Cela permet de réduire la transmission de la polarisation p sans réduire la transmission de la polarisation s.

Par ailleurs, plus la différence entre les indices n1 et n2 est importante et plus la plage de longueurs d'onde de transmission de la polarisation s est éloignée de la plage de longueurs d'onde de transmission de la polarisation p.

À titre d'exemple, le filtre optique 100 comprend des groupes de quatre régions adaptées à filtrer des rayonnements selon respectivement quatre orientations de polarisation différentes, par exemple des polarisations linéaires selon respectivement quatre directions formant respectivement des angles de 0°, 90°, 45° et 135° par rapport à une direction de référence. Chaque groupe de quatre régions est par exemple destiné à être placé en vis-à-vis d'un groupe de quatre pixels adjacents d'un capteur d'images. Dans cet exemple, les barres 115 et 117 des filtres polariseurs 113a et 113b des quatre régions du filtre optique 100 s'étendent latéralement selon respectivement quatre directions formant respectivement des angles de 0°, 90°, 45° et 135° par rapport à la direction de référence.

La figure 4 est une vue en perspective, schématique et partielle, d'un filtre optique 400 selon un mode de réalisation.

De manière analogue au filtre 100, le filtre 400 est par exemple destiné à être placé en vis-à-vis d'une matrice de pixels d'un capteur d'images, par exemple pour former un capteur multispectral ou hyperspectral. À titre de variante, le filtre optique 400 est adapté à transmettre un rayonnement incident majoritairement dans une seule plage de longueurs d'onde et selon une seule polarisation.

Dans l'exemple illustré en figure 4, le filtre optique 400 comprend des couches diélectriques 405 et 407 alternées. Les couches 405 sont en au moins un matériau isolant, ou diélectrique, présentant un indice optique, ou indice de réfraction, n5. En outre, les couches 407 sont en au moins un autre matériau isolant présentant un indice optique n6 strictement supérieur à l'indice optique n5.

À titre d'exemple, les matériaux des couches 405 et 407 sont choisis parmi :
- des oxydes, par exemple l'oxyde de silicium, l'oxyde de titane, l'oxyde de niobium, l'oxyde de tantale, etc. ;
- des nitrures, par exemple le nitrure de silicium ; et
- le silicium amorphe.

De préférence, les couches 405 sont en le même matériau isolant d'indice optique n5 et les couches 407 sont en le même matériau isolant d'indice optique n6. Cela facilite la conception et la fabrication du filtre 400. À titre d'exemple, les couches diélectriques 405 et 407 sont respectivement en oxyde de silicium et en nitrure de silicium. Dans cet exemple, les indices optiques n5 et n6 sont respectivement égaux à environ 1,5 et 2,02 pour un rayonnement présentant une longueur d'onde égale à environ 550 nm.

Dans l'exemple représenté, le filtre 400 comprend plus précisément, entre les milieux d'entrée 101 et de sortie 103, quatre empilements 409a, 409b, 409c et 409d de couches diélectriques 405 et 407 alternées. Dans cet exemple, l'empilement 409b est situé entre les empilements 409a et 409c et l'empilement 409c est situé entre les empilements 409b et 409d. Les empilements 409a, 409b, 409c et 409d forment par exemple chacun un réflecteur.

La figure 4 illustre un exemple dans lequel chaque empilement 409a, 409b, 409c, 409d comprend deux couches 405 et une couche 407 alternées, c'est-à-dire une couche 407 interposée entre deux couches 405. Cet exemple n'est toutefois pas limitatif et chaque empilement 409a, 409b, 409c, 409d peut, à titre de variante, comprendre des nombres de couches 405 et 407 différents de ceux représentés.

Chaque couche diélectrique 405, 407 présente par exemple une épaisseur E3 dite « quart d'onde », ou « λ/4n », c'est-à-dire une épaisseur sensiblement égale à la longueur d'onde λ centrale du filtre optique 400 divisée par quatre fois l'indice optique n5, n6 de la couche.

Selon un mode de réalisation, le filtre optique 400 comprend en outre des cavités résonnantes 411a, 411b et 411c. Dans l'exemple illustré en figure 4, la cavité résonnante 411a est interposée entre les empilements 409a et 409b, la cavité résonnante 411b est interposée entre les empilements 409b et 409c, et la cavité résonnante 411c est interposée entre les empilements 409c et 409d.

Chaque cavité résonnante 411a, 411c est par exemple constituée d'une couche en le matériau d'indice optique n6 présentant une épaisseur égale à au moins k fois le double de l'épaisseur E3 des couches 407. En outre, la cavité résonnante 411b comprend par exemple un filtre polariseur 413. Dans l'exemple illustré, le filtre polariseur 413 s'étend verticalement sur toute l'épaisseur de la cavité résonnante 411b et s'étend latéralement sur toute la surface de la cavité résonnante 411b. Dans cet exemple, le filtre polariseur 413 occupe l'intégralité du volume interne de la cavité résonnante 411b. Bien que la figure 4 illustre un exemple dans lequel le filtre polariseur 413 est intégré dans la cavité résonnante 411b, cet exemple n'est pas limitatif et le filtre polariseur 413 peut, à titre de variante, être intégré dans la cavité résonnante 411a ou dans la cavité résonnante 411c.

Dans l'exemple illustré, le filtre polariseur 413 comprend une structure périodique comportant des barres 415 et 417 alternées et parallèles entre elles, les barres 415 et 417 s'étendant latéralement le long d'une direction sensiblement horizontale. Les barres 415 sont par exemple en un matériau métallique présentant un indice optique n7 et les barres 417 sont par exemple en matériau isolant présentant un indice optique n8 strictement supérieur à l'indice optique n7. À titre d'exemple, les barres 415 sont en un métal, par exemple l'aluminium, l'argent, etc., ou en un alliage métallique. Les barres 417 sont par exemple en l'un des matériaux listés ci-dessus pour les couches 405 et 407.

À titre d'exemple, les barres 415 sont en aluminium et les barres 417 sont en oxyde de silicium.

Bien que la figure 4 illustre un exemple dans lequel le filtre optique 400 comprend deux cavités résonnantes 411a et 411c dépourvues de filtre polariseur et une seule cavité résonnante 411b comprenant un filtre polariseur, cet exemple n'est pas limitatif et le filtre optique 400 peut, à titre de variante, comprendre des nombres de cavités résonnantes différents de ceux représentés, étant entendu que l'une au moins des cavités résonnantes comporte un filtre polariseur.

Chaque cavité résonnante 411a, 411b, 411c présente par exemple une épaisseur E4 dite « demi-onde », ou « λ/2n », c'est-à-dire une épaisseur sensiblement égale à environ la longueur d'onde λ centrale du filtre optique 400 divisée par deux fois un indice optique effectif neff de la cavité résonnante. À titre de variante, chaque cavité résonnante 411a, 411b, 411c présente une épaisseur égale à k fois l'épaisseur E4.

Un avantage du filtre optique 400 est qu'il combine une fonction de filtrage interférentiel en longueurs d'onde avec une fonction de filtrage de la polarisation (polariseur) sans perte d'intensité lumineuse et tout en présentant une résilience à l'angle d'incidence bien supérieure à celle des filtres existants.

Divers modes de réalisation et variantes ont été décrits. La personne du métier comprendra que certaines caractéristiques de ces divers modes de réalisation et variantes pourraient être combinées, et d'autres variantes apparaîtront à la personne du métier.

En particulier, la personne du métier est capable de prévoir, à partir des indications de la présente description, de réaliser les barres 115 du filtre optique 100 en un matériau métallique, par exemple un matériau analogue à celui des barres 415 du filtre optique 400. Par ailleurs, la personne du métier est capable de prévoir, à partir des indications de la présente description, de réaliser les barres 415 du filtre optique 400 en un matériau diélectrique, par exemple un matériau analogue à celui des barres 115 du filtre optique 100.

Enfin, la mise en œuvre pratique des modes de réalisation et variantes décrits est à la portée de la personne du métier à partir des indications fonctionnelles données ci-dessus. En particulier, les modes de réalisation décrits ne se limitent pas aux exemples particuliers de matériaux et de dimensions mentionnés dans la présente description.

## Revendications

1. Filtre optique (100 ; 400) comprenant une superposition de :
- au moins des première (111a ; 411a) et deuxième (111b ; 411c) cavités résonnantes ; et
- au moins un premier filtre polariseur (113a ; 413), le filtre (100 ; 400) comprenant en outre :
A) un deuxième filtre polariseur (113b), les premier (113a) et deuxième (113b) filtres polariseurs étant respectivement situés dans les première (111a) et deuxième (111b) cavités résonnantes ; ou
B) une troisième cavité résonnante (411b) interposée entre les première (411a) et deuxième (411c) cavités résonnantes, chaque premier filtre polariseur (413) étant situé dans l'une des première (411a), deuxième (411c) et troisième (411b) cavités résonnantes.

2. Filtre optique (400) selon la revendication 1, dans l'option B), comprenant un seul premier filtre polariseur (413) situé de préférence dans la troisième cavité résonnante (411b).

3. Filtre optique (100 ; 400) selon la revendication 1 ou 2, dans lequel chaque cavité résonnante (111a, 111b ; 411a, 411b, 411c) est interposée entre des empilements (109a, 109b, 109c ; 409a, 409b, 409c, 409d) comprenant chacun une alternance :
- d'au moins deux premières couches (105 ; 405) en un premier matériau isolant présentant un premier indice optique ; et
- d'au moins une deuxième couche (107 ; 407) en un deuxième matériau isolant présentant un deuxième indice optique strictement supérieur au premier indice optique.

4. Filtre optique (100 ; 400) selon la revendication 3, dans lequel les premier et deuxième matériaux isolants sont choisis parmi :
- des oxydes, par exemple l'oxyde de silicium, l'oxyde de titane, l'oxyde de niobium, l'oxyde de tantale, etc. ;
- des nitrures, par exemple le nitrure de silicium ; et
- le silicium amorphe.

5. Filtre optique (100 ; 400) selon la revendication 3 ou 4, dans lequel chaque première couche (105 ; 405) et chaque deuxième couche (107 ; 407) présente une épaisseur quart d'onde.

6. Filtre optique (100 ; 400) selon l'une quelconque des revendications 1 à 5, dans lequel chaque cavité résonnante (111a, 111b ; 411a, 411b, 411c) présente une épaisseur demi-onde.

7. Filtre optique (100 ; 400) selon l'une quelconque des revendications 1 à 6, dans lequel chaque filtre polariseur (113a, 113b ; 413) comprend un réseau de barres parallèles alternées comportant :
- des premières barres (115 ; 415) en un troisième matériau présentant un troisième indice optique ; et
- des deuxièmes barres (117 ; 417) en un quatrième matériau isolant présentant un quatrième indice optique strictement supérieur au troisième indice optique.

8. Filtre optique (100 ; 400) selon la revendication 7, dans sa dépendance à la revendication 3, dans lequel les troisième et quatrième matériaux sont respectivement identiques aux premier et deuxième matériaux.

9. Filtre optique (100 ; 400) selon la revendication 7, dans lequel le troisième matériau est un matériau métallique, par exemple l'argent ou l'aluminium.

10. Filtre optique (100 ; 400) selon la revendication 7, dans l'option A), dans lequel les réseaux de barres des premier (113a, 113b) et deuxième filtres polariseurs présentent un pas identique.

11. Filtre optique (100 ; 400) selon la revendication 9, dans l'option A), dans lequel les réseaux de barres des premier (113a, 113b) et deuxième filtres polariseurs présentent des pas différents.

12. Filtre optique (100 ; 400) selon l'une quelconque des revendications 1 à 11, destiné à être placé en vis-à-vis d'une matrice de pixels d'un capteur d'images, le filtre optique (100 ; 400) étant adapté à transmettre un rayonnement incident majoritairement dans une première plage de longueurs d'onde et selon une première polarisation à certains pixels du capteur, et majoritairement dans au moins une deuxième plage de longueurs d'onde, différente de la première plage de longueurs d'onde, et/ou selon au moins une deuxième polarisation, différente de la première polarisation, à d'autres pixels du capteur.

13. Capteur multispectral ou hyperspectral comprenant un capteur d'images comportant une matrice de pixels en vis-à-vis desquels est situé un filtre optique (100 ; 400) selon l'une quelconque des revendications 1 à 12.
